(19) Europäisches Patentamt
European Patent Office
Office européen des brevets

(11) **EP 2 108 967 A1**

(12) **EUROPÄISCHE PATENTANMELDUNG**

(43) Veröffentlichungstag:
**14.10.2009   Patentblatt 2009/42**

(51) Int Cl.:
**G01R 19/25** (2006.01)      **G01R 21/133** (2006.01)

(21) Anmeldenummer: **08006934.7**

(22) Anmeldetag: **07.04.2008**

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**
Benannte Erstreckungsstaaten:
**AL BA MK RS**

(71) Anmelder: **SIEMENS AKTIENGESELLSCHAFT**
**80333 München (DE)**

(72) Erfinder:
• **Neumann, Bernhard**
  **90556 Cadolzburg (DE)**
• **Prölss, Manfred**
  **92263 Ebermannsdorf (DE)**
• **Schumann, Gordon**
  **91052 Erlangen (DE)**

(54) **Verfahren und Vorrichtung zur Ermittlung der elektrischen Wirkleistung mehrerer Verbraucherabzweige**

(57)   Die Erfindung betrifft ein Verfahren und eine Vorrichtung zur Ermittlung der Wirkleistung in mehreren Verbraucherabzweigen (1,2), die über einen Knotenpunkt (E)gespeist werden. Dabei wird nur die Spannung in dem Knotenpunkt(E) erfasst und hieraus der Spannungseffektivwert ermittelt. Außerdem wird in den Verbraucherabzweigen(1,2) jeweils der Strom erfasst und hieraus der jeweilige Stromeffektivwert ermittelt. Für jeden Verbraucherabzweig(1,2) wird die Phasenverschiebung zwischen dem zugehörigen Strom und der Spannung ermittelt. Hierzu wird für jeweils mindestens einen Spannungs- und Stromwert der zugehörige Zeitstempel (t) erfasst. Die Zeitstempel(t) sind synchronisiert. Nach Übertragung dieser Daten an eine Verarbeitungseinheit (V) ermittelt diese hiermit die Wirkleistung für jeden Verbraucherabzweig(1,2).

EP 2 108 967 A1

**Beschreibung**

Die Erfindung betrifft ein Verfahren zur Ermittlung der Wirkleistung von mehreren über einen Knotenpunkt gespeisten Verbraucherabzweigen und eine zugehörige Vorrichtung.

Für die Stromverbrauchsmessung werden bekanntlich elektrische Zähler, insbesondere in Haushalten, eingesetzt, die nach dem Ferraris-Prinzip arbeiten und die die elektrische Energie bzw. Arbeit messen, d.h., die über einen Zeitraum aufintegrierte Wirkleistung. Es gibt auch Zähler, die dies elektronisch tun. Dabei besteht die Möglichkeit, die Effektivwerte von Strom $I_{eff}$ und Spannung $U_{eff}$ zu messen und den Leistungsfaktor cos φ bei sinusförmigem Verlauf aus der Phasenverschiebung von Strom und Spannung bei sinusförmigem Verlauf zu bestimmen. Die Wirkleistung lässt sich dann nach folgender Gleichung ermitteln:

$$P = U_{eff} \times I_{eff} \times \cos \varphi.$$

Motormanagementsysteme sollen nicht nur die Wirkleistung eines einzelnen Motors erfassen, sondern auch die Wirkleistung einer Gruppe von Motoren, die z.B. zentral über einen Knotenpunkt gespeist werden. Dabei muss einerseits die Spannung und an unterschiedlichen, dem Einsatz der Motoren entsprechenden Stellen der Strom erfasst werden, wobei trotz unterschiedlicher Laufzeiten bei der Übertragung der erfassten Strom- und Spannungswerte deren zeitlicher Bezug nicht verloren gehen darf.

Der Erfindung liegt die Aufgabe zugrunde, ein Verfahren der o.g. Art auch anzugeben, das die Wirkleistungsermittlung auf besonders einfache Weise ermöglicht.

Außerdem besteht die Aufgabe, eine entsprechende Vorrichtung vorzuschlagen.

Die erste Aufgabe wird mit dem Verfahren mit den Merkmalen nach Anspruch 1 gelöst. Vorteilhafte Weiterbildungen des Verfahrens sind den Unteransprüchen 2 und 5 zu entnehmen.

Die weitere Aufgabe wird durch eine Vorrichtung mit den Merkmalen nach Anspruch 6 gelöst. Vorteilhafte Weiterbildungen der Vorrichtung sind den Unteransprüchen 7 bis 12 zu entnehmen.

Ein Ausführungsbeispiel der Erfindung wird im Folgenden anhand einer Figur näher erläutert.

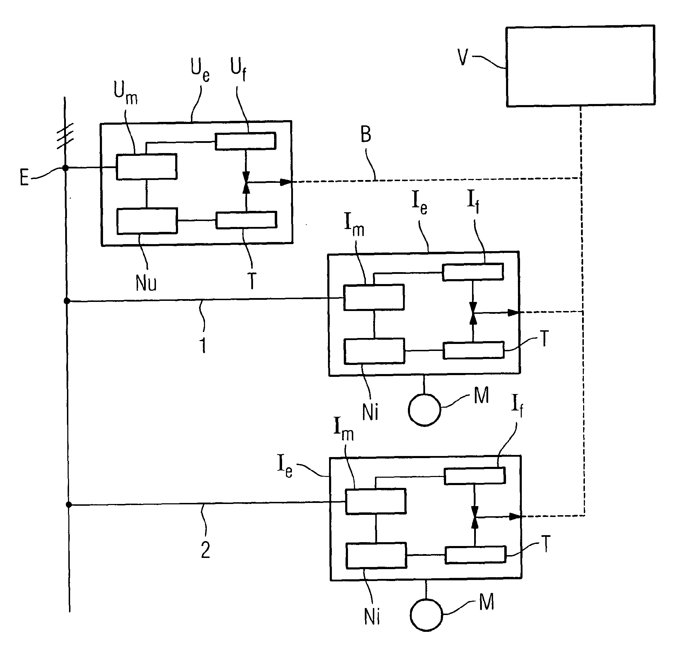

In der Figur ist eine Vorrichtung zur Ermittlung der Wirkleistung zweier Verbraucherabzweige 1 und 2 dargestellt, in denen jeweils als Verbraucher M ein Motor vorhanden ist. Beide Verbraucherabzweige 1 und 2 werden über den Knotenpunkt E als zentrale Einspeisung versorgt. Hierbei ist die Spannung für beide Verbraucherabzweige 1,2 nahezu gleich, so dass nur eine einzige Spannungsmessung für die Ermittlung der Wirkleistung beider Verbraucherabzweige 1 und 2 erforderlich ist. Die Genauigkeitseinbuße ist bei geringen Spannungsunterschieden zwischen den Abgängen der Verbraucherabzweige 1 und 2 und dem Knotenpunkt E vernachlässigbar. Somit sind für die Ermittlung der Wirkleistung nur eine Spannungserfassungseinheit $U_e$ im Knotenpunkt E und zwei Stromerfassungseinheiten $I_e$ vorgesehen, die allesamt grundsätzlich gleich aufgebaut sind und über ein Bussystem B als Datenübertragung mit einer Verarbeitungseinheit V in Verbindung stehen, die z.B. als Motormanagementsystem ausgeführt sein kann.

Die Spannungserfassungseinheit $U_e$ weist eine Spannungserfassung Um auf, mit der nach Transformation der Spannung auf einen für die Weiterverarbeitung geeigneten Spannungspegel einzelne Spannungswerte, z.B. durch Abtastung erfasst werden. Es kann auch eine Transformation mittels Spannungsteiler durchgeführt werden. Die Spannungserfassungseinheit $U_e$ umfasst eine Messwerterfassung Um, Mittel Uf zur Bestimmung des Effektivwerts der erfassten Spannung, eine Nulldurchgangserfassung Nu zur Ermittlung mindestens eines Nulldurchgangs der Spannung und Mittel T zur Erfassung des Zeitstempels t zu mindestens einem der erfassten Nulldurchgänge.

Die Stromerfassungseinheit $I_e$ umfasst eine Messwerterfassung Im, Mittel If zur Bestimmung des Effektivwerts des erfassten Stromes, eine Nulldurchgangserfassung Ni zur Ermittlung mindestens eines Nulldurchgangs des Stromes und Mittel T zur Erfassung des Zeitstempels t zu mindestens einem der erfassten Nulldurchgänge des Stromes.

Die Mittel T zur Erfassung des Zeitstempels t in den Stromerfassungseinheiten $I_e$ und der Spannungserfassungseinheit $U_e$ sind synchronisiert und beispielsweise als Timer ausgeführt. Dabei können die Zeitstempel t die gemessene absolute Zeit angeben.

Die Spannungs- $U_e$ und Stromerfassungseinheiten $I_e$ übertragen die Effektivwerte von Strom und Spannung und die Zeitstempel t für die Nulldurchgänge an die Verarbeitungseinheit V über das bestehende Bussystem B oder eine andere Datenübertragung. Die Verarbeitungseinheit V ermittelt hieraus die Wirkleistung für jeden Verbraucherabzweig 1,2 und ggf. auch die Summe hiervon.

Die Besonderheit an der oben beschriebenen Vorrichtung und dem zugehörigen Verfahren zur Ermittlung der Wirkleistung besteht in der räumlichen und funktionalen Trennung der zur Erfassung erforderlichen Komponenten. Durch die dezentrale Ermittlung der Effektwerte von Strom und Spannung und die zusätzliche Erfassung der Nulldurchgänge von Strom und Spannung sowie der betreffenden Zeitstempel t wird der zu übertragenden Datenumfang zur Realisierung eines Motormanagements minimiert, ohne dass sich daraus Nachteile hinsichtlich der Genauigkeit ergeben. Als besonders vorteilhaft ist die Reduzierung der Anforderungen der Übertragungsgeschwindigkeit des eingesetzten Bussystems B zu nennen.

Anstelle der Nulldurchgänge von Strom und Spannung kann auch für andere typische Strom- und Spannungswerte, z.B. für die jeweiligen Maximal- oder Minimalwerte, der Zeitstempel t erfasst werden. Diese Information der jeweiligen Strom- und Spannungswerte und der zugehörigen Zeitstempel t muss der Verarbeitungseinheit V vorliegen, damit sie hieraus die Phasenverschiebung zwischen Strom und Spannung für die Wirkleistungsberechnung ermitteln kann.

Vorzugsweise sind die Spannungserfassungseinheit $U_e$ und die Verarbeitungseinheit V im gleichen Gehäuse angeordnet.

**Patentansprüche**

1. Verfahren zur Ermittlung der Wirkleistung in mehreren Verbraucherabzweigen (1,2), die über einen Knotenpunkt (E) gespeist werden, in folgenden Schritten:

   a) es wird nur die Spannung in dem Knotenpunkt (E) erfasst und hieraus der Spannungseffektivwert ermittelt,
   b) es wird in den Verbraucherabzweigen (1,2) jeweils der Strom erfasst und hieraus der jeweilige Stromeffektivwert ermittelt,
   c) es wird für jeden Verbraucherabzweig (1,2) jeweils die Phasenverschiebung zwischen dem zugehörigen Strom und der Spannung in dem Knotenpunkt (E) ermittelt, wozu mindestens für einen im Knotenpunkt (E) gemessenen Spannungswert und für einen in dem jeweiligen Verbraucherabzweig (1,2) gemessenen Stromwert der zugehörige Zeitstempel (t) erfasst wird, wobei die Zeitstempel (t) synchronisiert sind.

2. Verfahren nach Anspruch 1, **dadurch gekennzeichnet, dass** als Spannungs- und Stromwert jeweils der Nulldurchgang dient.

3. Verfahren nach Anspruch 1, **dadurch gekennzeichnet, dass** als Spannungs- und Stromwert jeweils der Maximal- oder Minimalwert dient.

4. Verfahren nach Anspruch 1, **dadurch gekennzeichnet, dass** der Effektivwert der Spannung, die Effektivwerte der Ströme und die erfassten Zeitstempel (t) an eine Verarbeitungseinheit (V) übertragen werden, die hiermit die Wirkleistung der Verbraucherabzweige (1,2) ermittelt.

5. Verfahren nach Anspruch 1 oder 2, **dadurch gekennzeichnet, dass** die Synchronisation der Zeitstempel (t) über eine Datenübertragung (B) erfolgt.

6. Vorrichtung zur Ermittlung der elektrischen Wirkleistung in mehreren über einen Knotenpunkt gespeisten Verbraucherabzweigen (1,2), mit jeweils einer Stromerfassungseinheit ($I_e$) in den Verbraucherabzweigen (1,2), mit nur einer Spannungserfassungseinheit ($U_e$) im Knotenpunkt (E), mit einer Verarbeitungseinheit (V), mit einer Datenübertragung (B) zwischen der Verarbeitungseinheit (V), der Spannungserfassungseinheit ($U_e$) sowie den Stromerfassungseinheiten ($I_e$), wobei die Spannungs- ($U_e$) und die Stromerfassungseinheiten ($I_e$) jeweils eine Messwerterfassung (Um oder Im), Mittel (Uf oder If) zur Bestimmung des Effektivwerts der erfassten Spannung bzw. des erfassten Stromes, und Mittel (T) zur Erfassung des Zeitstempels (t) für mindestens einen im Knotenpunkt (E) gemessenen Spannungswert und für mindestens einen in dem jeweiligen Verbraucherabzweig (1,2) gemessenen Stromwert aufweist, wobei die jeweiligen Mittel (T) zur Erfassung des Zeitstempels (t) zum Spannungs- und Stromwert synchronisiert sind.

7. Vorrichtung nach Anspruch 6, **dadurch gekennzeichnet, dass** als Spannungs- und Stromwert jeweils der Nulldurchgang dient.

8. Vorrichtung nach Anspruch 6, **dadurch gekennzeichnet, dass** als Spannungs- und Stromwert jeweils der Maximal- oder Minimalwert dient.

9. Vorrichtung nach einem der vorangehenden Ansprüche 6 bis 8, **dadurch gekennzeichnet, dass** als Mittel (T) zur Erfassung des Zeitstempels (t) in den Stromerfassungseinheiten ($I_e$) und der Spannungserfassungseinheit ($U_e$) synchronisierte Timer vorgesehen sind.

10. Vorrichtung nach Anspruch 6 oder 9, **dadurch gekennzeichnet, dass** als Datenübertragung (B) ein Bussystem vorgesehen ist.

11. Vorrichtung nach einem der vorangehenden Ansprüche 6 bis 10, **dadurch gekennzeichnet, dass** die Verarbeitungseinheit (V) als ein Gerät zum Management mehrerer Verbraucherabzweige (1,2) ausgeführt ist.

12. Vorrichtung nach einem der vorangehenden Ansprüche 6 bis 11, **dadurch gekennzeichnet, dass** die Verbraucherabzweige (1,2) als Motorabzweige ausgeführt sind.

Europäisches
Patentamt

**EUROPÄISCHER RECHERCHENBERICHT**

Nummer der Anmeldung

EP 08 00 6934

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 0 853 364 A (SACE SPA [IT]) 15. Juli 1998 (1998-07-15) * das ganze Dokument * ----- | 1-12 | INV. G01R19/25 G01R21/133 |
| X | US 6 459 257 B1 (KOECK GERD [DE]) 1. Oktober 2002 (2002-10-01) * das ganze Dokument * ----- | 1-12 | |

**RECHERCHIERTE SACHGEBIETE (IPC)**

G01R

Der vorliegende Recherchenbericht wurde für alle Patentansprüche erstellt

| Recherchenort | Abschlußdatum der Recherche | Prüfer |
|---|---|---|
| Den Haag | 27. August 2008 | Koll, Hermann |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

&: Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 08 00 6934

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-08-2008

| Im Recherchenbericht angeführtes Patentdokument | | Datum der Veröffentlichung | Mitglied(er) der Patentfamilie | | Datum der Veröffentlichung |
|---|---|---|---|---|---|
| EP 0853364 | A | 15-07-1998 | IT | 1286463 B1 | 08-07-1998 |
| US 6459257 | B1 | 01-10-2002 | AT | 221667 T | 15-08-2002 |
| | | | WO | 9912047 A1 | 11-03-1999 |
| | | | DE | 19738140 A1 | 11-03-1999 |
| | | | EP | 1010015 A2 | 21-06-2000 |

EPO FORM P0461

Für nähere Einzelheiten zu diesem Anhang : siehe Amtsblatt des Europäischen Patentamts, Nr.12/82